# EUROPÄISCHE PATENTSCHRIFT

(11) **EP 3 161 852 B1**
(45) Veröffentlichungstag und Bekanntmachung des Hinweises auf die Patenterteilung: **27.06.2018**
(21) Anmeldenummer: 14741520.2
(22) Anmeldetag: 30.06.2014
(51) Int. Cl.: H01J 37/147

(54) **ELEKTRONENSTRAHLTEILER**
ELECTRON BEAM SPLITTER
SÉPARATEUR DE FAISCEAU D'ÉLECTRONS

(43) Veröffentlichungstag der Anmeldung: 03.05.2017
(73) Patentinhaber: Friedrich-Alexander-Universität Erlangen-Nürnberg, 91054 Erlangen (DE)
(72) Erfinder: HAMMER, Jakob, 80796 München (DE); HOMMELHOFF, Peter, 91052 Erlangen (DE)
(74) Vertreter: FDST Patentanwälte
(86) Internationale Anmeldenummer: PCT/EP2014/001784
(87) Internationale Veröffentlichungsnummer: WO 2016/000726

(56) Entgegenhaltungen:
- US-A1- 2008 302 965
- HOFFROGGE J ET AL: "Planar microwave structures for electron guiding", NEW JOURNAL OF PHYSICS, INSTITUTE OF PHYSICS PUBLISHING, BRISTOL, GB, Bd. 13, Nr. 9, 20. September 2011 (2011-09-20), Seite 95012, XP020210220, ISSN: 1367-2630, DOI: 10.1088/1367-2630/13/9/095012
- HÄNSEL W ET AL: "Trapped-Atom-Interferometer in a Magnetic Microtrap", ARXIV.ORG, CORNELL UNIVERSITY LIBRARY, 201 OLIN LIBRARY CORNELL UNIVERSITY ITHACA, NY 14853, 28. Juni 2001 (2001-06-28), XP080053659, DOI: 10.1103/PHYSREVA.64.063607

## Beschreibung

Die Erfindung betrifft einen Elektronenstrahlteiler. Ein solcher Elektronenstrahlteiler stellt ein wesentliches Bauteil der Elektronenoptik dar, und kommt beispielsweise in der Elektronenmikroskopie zur Anwendung. Der angegebene Elektronenstrahlteiler eignet sich insbesondere zur Manipulation von Elektronen mit einer Energie zwischen 1 eV und 10 eV, wie sie in der Niedrig-Energie-ElektronenMikroskopie oder in zukünftigen kommerziellen Elektronen-Mikroskopen mit einer verringerten Strahlenbelastung für die untersuchte Probe eingesetzt werden. Der angegebene Energiebereich ist insofern insbesondere zur Untersuchung biologischer Proben interessant.

In der klassischen Elektronenoptik werden Elektronenstrahlen anhand ihrer elektrischen Ladung mit Hilfe statischer elektrischer und/oder magnetischer Felder transversal fokussiert. Aufgrund der kurzen De-Broglie-Wellenlänge der massebehafteten Elektronen kann mit Hilfe von Elektronenstrahlen Mikroskopie bei höchster Auflösung betrieben werden. In modernen Transmissions-Elektronen-Mikroskopen ist z.B. eine subatomare Auflösung möglich. Ein Strahlteiler ist dabei ein entscheidendes Bauteil in jedem experimentellen Aufbau, der auf Interferenz von Licht- oder Materiewellen beruht. Materiewellen-Interferenz findet in der Elektronen-Mikroskopie beispielsweise Anwendung in der Messung des mittleren inneren Potenzials einer Probe und der Bestimmung der Probendicke, in der Messung von Kontaktpotenzialen, in der Messung von magnetischem Fluss und magnetischer Domänen, in der der Vermessung elektrischer und magnetischer Felder, in Oberflächenuntersuchungen, in der Messung der Kohärenz und des Richtstrahlwerts einer Elektronenquelle, in der Elektronenholographie sowie in der Interferenzlithographie.

Das Feld der Elektronenholographie wurde ursprünglich vorangetrieben, um hoch auflösende Elektronenmikroskopie zu betreiben und dabei auf komplizierte und teure Abbildungskorrekturen für die Elektronenoptik zu verzichten. Inzwischen findet Elektronenholographie bei kommerziellen Herstellern ein besonderes Interesse, da hierbei Proben einer verringerten Strahlungsdosis ausgesetzt werden. Einem Elektronenstrahlteiler der vorgenannten Art kommt dabei eine entscheidende Bedeutung zu.

In vielen derzeit kommerziell erhältlichen Elektronenmikroskopen, die Materiewellen-Interferenz ausnutzen, wird ein sogenanntes elektrostatisches Biprisma als Elektronenstrahlteiler eingesetzt, wobei der Elektronenstrahl an einem geladenen Biprismafaden gebeugt werden. Beim Aufspalten eines Elektronenstrahls mit dem elektrostatischen Biprisma trifft jedoch unvermeidlich ein gewisser Anteil des Elektronenstrahls den Biprismafaden und geht daher verloren. Andere Ansätze für einen Elektronenstrahlteiler sind die Beugung an einem Kristall, wobei jedoch Verluste in höheren Beugungsordnungen auftreten. Zudem müssen hohe Stabilitätsanforderungen erfüllt sein. Es wird nur eine kleine Aufspaltung des Elektronenstrahls erreicht. Eine Aufspaltung des Elektronenstrahls mittels eines Doppelspalts weist den Nachteil einer geringen Transmission auf. Ein magnetisches Biprisma ist schlecht durchstimmbar. Zudem ist die Transmission für Elektronen durch magnetisches Material reduziert, was eine Reduktion der Kohärenz zur Folge hat. Ein anderer Ansatz ist die Verwendung eines optischen Kabitza-Dirac-Gitters, wobei ein Elektronenstrahl an einer stehenden Lichtwelle gebeugt wird. Auch für diese Methode sind hohe technische Anforderungen zu erfüllen. All diese Ansätze eines Elektronenstrahlteilers sind nachteiligerweise nicht sehr robust und sehr empfindlich gegenüber äußeren Störungen.

Eine wichtige Anforderung an einen Elektronenstrahlteiler ist es insbesondere, dass eine Probe in einen Arm eines Interferometers platziert werden kann. Dazu ist eine große Aufspaltung der Elektronenstrahlen zumindest im Bereich von einigen µm notwendig. Im Falle der technisch eingesetzten elektrostatischen Biprismen werden dazu oft einige Biprismafäden zueinander justiert und nacheinander verwendet, um so eine Aufspaltung von einigen 10 µm zu erreichen.

Der Erfindung liegt die Aufgabe zugrunde, einen Elektronenstrahlteiler mit einer möglichst verlustfreien Aufspaltung der Elektronenstrahlen anzugeben. Weiter soll der Elektronenstrahlteiler möglichst einfach eine große Aufspaltung der Elektronenstrahlen ermöglichen und zudem möglichst robust gegenüber äußeren Störungen sein.

Die gestellte Aufgabe wird erfindungsgemäß durch einen Elektronenstrahlteiler gelöst, der eine mehrpolige, mit einer hochfrequenten Wechselspannung beaufschlagbare Elektrodenanordnung umfasst, die sich entlang eines vorgegebenen Pfades von einer Eintrittsseite zu einer Austrittsseite erstreckt, wobei die Elektrodenanordnung an der Eintrittsseite mit einer ersten Anzahl von spannungsbeaufschlagten Elektroden ein erstes oszillierendes elektrisches Feld erzeugt, das in einer Transversalebene zeitgemittelt ein einzelnes lokales Einschlussminimum bildet, und wobei die Elektrodenanordnung zumindest an der Ausgangsseite mit einer zweiten Anzahl von spannungsbeaufschlagten Elektroden ein zweites oszillierendes elektrisches Feld erzeugt, das in einer Transversalebene wenigstens zwei lokale Einschlussminima bildet.

Der angegebene Elektronenstrahlteiler vereint damit die klassische Elektronenoptik mit dem Funktionsprinzip einer linearen Paulfalle. Die lineare Paulfalle basiert insbesondere auf alternierenden elektrischen Quadrupol-Feldern. Mit Hilfe der rasch oszillierenden Felder kann ein stabiler transversaler Einschluss geladener Teilchen erzeugt werden, der durch ein zeitlich gemitteltes Pseudopotenzial beschrieben werden kann (Physik-Nobelpreis an Wolfgang Paul im Jahr 1989). Das Prinzip der linearen Paulfalle findet inzwischen erfolgreich Anwendung in Massenspektrometern und Ionenfallen.

Die Erfindung geht in einem ersten Schritt von der Überlegung aus, nach dem Prinzip der linearen Paulfalle einen Elektronenstrahl entlang einer Trajektorie zu führen, ohne dass die oszillierenden Felder Einfluss auf die Vorwärts- oder Longitudinalrichtung des Elektrons nehmen. In transversaler Richtung ist das Elektron und somit der Elektronenstrahl jedoch eingeschlossen bzw. lokalisiert. Im Falle eines Quadrupol-Feldes ergibt sich für die Paulfalle in transversaler Richtung näherungsweise ein parabelförmiges Pseudopotenzial, welches ein einzelnes lokales Einschlussminimum aufweist.

In einem zweiten Schritt erkennt die Erfindung, dass durch Anwendung der Idee der Paulfalle Elektronen insofern entlang einer durch die Elektrodenanordnung vorgegebenen Trajektorie, insbesondere auch adiabatisch ohne energetische Anregung und hierbei insbesondere im jeweiligen Grundzustand verbleibend, geführt werden können.

In einem dritten Schritt geht die Erfindung von der weiteren Überlegung aus, dass durch Multipol-Felder höherer Ordnung nach diesem Prinzip auch Pseudopotenziale erzeugt werden können, die in transversaler Richtung bezüglich der Trajektorie zwei oder mehr lokal getrennte Einschlussminima aufweisen. Insbesondere können durch Multipol-Felder höherer Ordnung auch Kreuzungsbereiche im Bild der Pseudopotenziale erzeugt werden, wozu beispielsweise auf J.H. Wesenberg, "Idial intersections for radio-frequency trap networks" in Physical Review A 79,013416 (2009) verwiesen ist.

Dementsprechend sieht die Erfindung vor, mit einer ersten Anzahl von Elektroden an der Eingangsseite einen Elektronenstrahl durch ein aus dem ersten oszillierenden elektrischen Feld resultierendes Pseudopotenzial mit einem einzigen lokalen Minimum zu führen, während an der Ausgangsseite mit einer zweiten Anzahl von Elektroden mittels eines zweiten oszillierenden elektrischen Felds ein zweites Pseudopotenzial zur Führung der Elektronen erzeugt wird, welches wenigstens zwei lokale Minima in transversaler Richtung aufweist. Insbesondere wird entlang des Pfades ein oszillierendes elektrisches Feld erzeugt, dessen Multipol-Anteile höherer Ordnung in Bewegungsrichtung der Elektronen zunehmen. Hierdurch kann im Pseudopotenzial ein Kreuzungsbereich, und somit insbesondere ein Übergang einer einzelnen geführten Elektronen-Trajektorie in wenigstens zwei geführte Einzel-Trajektorien, geschaffen werden, wodurch der Elektronenstrahlteiler realisiert ist.

Wie bereits erwähnt, ergibt sich das Pseudopotenzial durch eine zeitliche Mittelung über das durch die Elektrodenanordnung erzeugte oszillierende elektrische Feld. Für Elektronen mit einer Energie zwischen 1 eV und 10 eV liegt hierbei die Frequenz der angelegten Spannung in einem Bereich zwischen 500 MHz und 500 GHz, also typischerweise im Mikrowellenbereich. Unter diesen Annahmen lässt sich das von den Elektronen im oszillierenden Feld gesehene Potenzial als quasistatisch, also als Pseudopotenzial, beschreiben. Die an die Elektrodenanordnung angelegte Wechselspannung beträgt bevorzugt zwischen 1V und 1000V.

Da die oszillierenden elektrischen Felder die Elektronen in Vorwärtsrichtung nicht beeinflussen, also für den Elektronenstrahl lediglich einen transversalen Einschluss bilden, arbeitet der angegebene Elektronenstrahlteiler im Wesentlichen verlustfrei. Lediglich im Kreuzungsbereich bzw. im Bereich der Aufspaltung der Elektronentrajektorie muss ein kleiner Anteil der vorwärtsgerichteten Energie in eine transversale Komponente umgewandelt werden, wozu in Vorwärtsrichtung eine Barriere für das Elektron existiert. Durch den Aufbau der Elektrodenanordnung kann an der Ausgangsseite des Elektronenstrahlteilers insbesondere ein oszillierendes Feld derart erzeugt werden, dass die in transversaler Richtung gebildeten lokalen Minima im mm-Bereich voneinander beanstandet sind. Der angegebene Elektronenstrahlteiler ermöglicht somit auch eine große Aufspaltung des Elektronenstrahls, was insbesondere für interferrometrische Anwendungen äußerst vorteilhaft ist.

Der angegebene Elektronenstrahlteiler ermöglicht insbesondere eine adiabatische Auftrennung des Elektronenstrahls, wobei die Elektronen auch nach Trennung in den wenigstens zwei Einzel-Trajektorien in ihrem Grundzustand weiter geführt werden. Hierbei muss insbesondere beachtet werden, dass im Kreuzungsbereich des Pseudopotenzials die Elektronen eine möglichst geringe Impulsänderung in Vorwärtsrichtung erfahren. Dies kann durch eine Optimierung der Elektrodenkonfiguration im Sinne einer möglichst parallelen Aufspaltung erzielt werden.

Bevorzugt ist dazu die Elektrodenanordnung derart ausgebildet, dass in einem Übergangsbereich eines einzelnen lokalen Einschlussminimums auf zwei lokale Einschlussminima der Öffnungswinkel α zwischen den beiden lokalen Einschlussminima zwischen 0,005° und 0,04° beträgt. Hierzu durchgeführte experimentelle Untersuchungen haben ergeben, dass dieser Winkelbereich für kinetische Energien der Elektronen zwischen 1 eV und 10 eV zu einem vernachlässigbaren Energieverlust des Elektrons in Vorwärtsrichtung führt und insofern für eine adiabatische Aufspaltung günstig ist. Dabei ist der Öffnungswinkel α umso kleiner zu wählen, je größer die kinetische Energie der Elektronen ist. Weitere experimentelle Untersuchungen haben ergeben, dass es hinsichtlich der adiabatischen Aufspaltung für Elektronen einer kinetischen Energie zwischen 1 eV und 10 eV ebenfalls vorteilhaft ist, wenn die Länge der Elektrodenanordnung entlang des Pfades zwischen 1 mm und 100 mm, bevorzugt zwischen 10 mm und 50 mm, beträgt. Dabei ist die Länge der Elektrodenanordnung umso länger zu wählen, je größer die kinetische Energie der Elektronen ist. Typische Frequenzen der Wechselspannung sind hierbei einige 10 GHz.

In einer weiter vorteilhaften Ausgestaltung des Elektronenstrahlteilers ist die zweite Anzahl von Elektroden gegenüber der ersten Anzahl von Elektroden erhöht. Dadurch kann Bezug genommen werden auf die Erhöhung der Multipolanteile höherer Ordnung im elektrischen Feld in Vorwärtsrichtung bzw. entlang des Pfades von der Eingangsseite des Elektronenstrahlteilers zu seiner Ausgangsseite.

Bevorzugt sind die Elektroden der Elektrodenanordnung an der Eingangsseite derart angeordnet und ausgebildet, dass sie unter Spannungsbeaufschlagung ein oszillierendes elektrisches Feld mit einem Quadrupol-Anteil erzeugen. Hierdurch wird es möglich, einen von einer Elektronenstrahlquelle erzeugten Elektronenstrahl durch das Einschlusspotenzial des Quadrupol-Feldes sehr gut einzufangen und auszurichten, bevor die eingefangenen oder eingekoppelten Elektronen in einen Kreuzungsbereich mit Multipol-Anteilen höherer Ordnung gelangen. Durch das Ausrichten der Elektronen-Trajektorie mittels eines eingangsseitigen Quadrupol-Feldes und somit eines transversal quadratischen Pseudopotenzials wird auch verhindert, dass einzelne Elektronen den Einschlussbereich entlang des Strahlteilers in transversaler Richtung unerwünscht verlassen.

Weiter bevorzugt sind die Elektroden der Elektrodenanordnung der Eingangsseite nachfolgend derart angeordnet und ausgebildet, dass sie ein oszillierendes elektrisches Feld mit einem Hexapol-Anteil oder mit einem Multipol-Anteil noch höherer Ordnung, beispielsweise mit einem Oktopol-Anteil etc., erzeugen. Ein Hexapol-Anteil ist insofern erstrebenswert, da der Elektroneneinschluss durch das resultierende Pseudopotenzial umso höher ist, je niedriger die Multipol-Ordnung ist. Da ein Hexapol-Feld das Feld niedrigster Ordnung ist, mit dem sich ein Kreuzungsbereich im Pseudopotenzial erzielen lässt, ist die Ausgestaltung eines Hexapol-Feldes zur Ausbildung des Strahlteilerbereichs zu bevorzugen. Durch ein Hexapol-Feld kann nach dem Kreuzungsbereich auch das gewünschte Pseudopotenzial erzeugt werden, welches zwei lokale Minima aufweist, wobei die Elektronen im Bereich der Minima jeweils näherungsweise ein Quadrupol-Feld wahrnehmen und insofern sicher transversal eingeschlossen bzw. in longitudinaler Richtung sicher geführt sind.

Vorteilhafterweise sind weiter die Elektroden der Elektrodenanordnung an der Ausgangsseite derart angeordnet und ausgebildet, dass sie ein oszillierendes elektrisches Feld mit wenigstens zwei in Transversalrichtung zueinander versetzten Quadrupol-Anteilen erzeugen. Auf diese Weise wird es möglich, die wenigstens zwei Elektronenteilstrahlen in einfacher Weise zu manipulieren und insbesondere entlang vorgesehener Pfade auseinanderzuführen. Hierdurch wird es möglich, eine große und insbesondere adiabatische Aufspaltung der Elektronenstrahlen zu erzielen.

Zweckmäßigerweise weist die Elektrodenanordnung an der Ausgangsseite eine wenigstens zweifach in Transversalrichtung vervielfältigte Struktur der Eingangsseite auf. Mit anderen Worten zeigt die Ausgangsseite insbesondere eine verdoppelte Struktur der Eingangsseite, wobei die Elektronen der Teilstrahlen beispielsweise wiederum jeweils im Pseudopotenzial eines oszillierenden Quadrupol-Feldes longitudinal geführt sind.

In einer weiter bevorzugten Ausgestaltung des Elektronenstrahlteilers umfasst die Elektrodenanordnung entlang des Pfades in einer ersten Gruppe von Elektroden eine Mittenelektrode sowie zwei die Mittenelektrode flankierende Begleitelektroden und in einer zweiten Gruppe von Elektroden zwei jeweils zwischen einer Begleitelektrode und der Mittenelektrode angeordnete Zwischenelektroden sowie zwei jeweils den Begleitelektroden bezogen von der Mittenelektrode weg außen angrenzende Außenelektroden, wobei die Elektroden innerhalb einer Gruppe jeweils elektrisch miteinander verbunden sind, und wobei die Elektroden der ersten Gruppe und die Elektroden der zweiten Gruppe zueinander elektrisch isoliert sind. Im Betrieb werden die Elektroden der ersten Gruppe und die Elektroden der zweiten Gruppe mit der hochfrequenten Wechselspannung beaufschlagt. Durch diese Elektrodenkonfiguration, die sich entlang der Elektronen-Trajektorie bzw. entlang des vorgegebenen Pfades erstreckt, wird es möglich, den Elektronenstrahl in Ausbreitungsrichtung in gewünschter Weise durch einen Übergang eines Quadrupol-Feldes über ein Hexapol-Feld in getrennte Quadrupol-Felder insbesondere kohärent und/oder adiabatisch aufzuspalten. Dazu ist insbesondere die Mittenelektrode in ihrer Länge reduziert, so dass an der Eingangsseite die Zwischenelektroden sich zu einer Elektrode vereinigen. Dadurch nimmt ein Elektron an der Eingangsseite zunächst ein Quadrupol-Feld wahr, ehe es in einen Bereich mit einem Multipol-Feld höherer Ordnung gelangt.

In einer besonders bevorzugten Ausgestaltung sind die Elektroden der Elektrodenanordnung auf einer Fläche, insbesondere auf einer Ebene, angeordnet. Dabei nimmt die Erfindung Bezug auf die Abbildung einer beispielsweise zylinderförmigen Multipol-Anordnung auf eine Fläche oder Ebene, wobei die geschlossene Multipol-Anordnung gedanklich in Längsrichtung in einem Pol aufgetrennt und auf eine Fläche bzw. auf eine Ebene abgerollt wird. Es lässt sich zeigen, dass durch diese konforme Abbildung der durch Pseudopotenziale beschriebene transversale Einschluss eines Elektrons in der Nähe des Potenzialminimums erhalten bleibt. Die jeweils durch Pseudopotenziale angegebenen lokalen Einschlussminima befinden sich dabei jeweils oberhalb der Fläche bzw. Ebene. Der Abstand eines lokalen Einschlussminimums zur Fläche bzw. Ebene liegt hierbei typischerweise in einem Bereich von einigen 100 µm. Mit anderen Worten werden die Elektronen bei einer abgerollten Elektrodenanordnung mit Abstand zu dieser longitudinal geführt.

Die Anordnung der Elektroden auf einer Fläche, die insbesondere auch gekrümmt oder gefaltet sein kann, ermöglicht es, den Elektronenstrahlteiler als ein flaches Bauteil, insbesondere in Form eines strukturierten Mikrowellensubstrats oder dergleichen herzustellen. Ein solches Bauteil bzw. ein solcher Strahlteiler-Chip eignet sich als modularer Einsatz in einem Elektronenmikroskop. Seine Bauform kann hierbei insbesondere an die lokal gegebenen Einbaugeometrien angepasst werden.

Zweckmäßigerweise sind die Elektroden selbst jeweils als leitfähige Schichten auf einem Substrat angeordnet. Bevorzugt ist dabei das Substrat doppelseitig leitfähig beschichtet. Die Elektroden der zweiten Gruppe sind hierbei zweckmäßigerweise als eine zusammenhängende elektrisch leitfähige Schicht gebildet, in welcher Schicht die Elektroden der ersten Gruppe elektrisch isoliert eingebettet sind.

Mit anderen Worten können die Elektroden bei der vorbeschriebenen Bauweise beispielsweise chemisch aus einem leitfähig beschichteten Substrat herausgearbeitet werden. Als leitfähige Beschichtung kann für Mikrowellenanwendungen beispielsweise Kupfer oder Gold eingesetzt sein. Ein geeignetes Substrat zeichnet sich durch eine vergleichsweise niedrige Dielektrizitätskonstante und durch geringe Mikrowellen-Verlustfaktoren aus. Als Substrat eignet sich beispielsweise ein Teflonlaminat. Die beidseitige Beschichtung des Substrats ermöglicht es, die Elektroden beidseitig, beispielsweise über Durchkontaktierungen, mit einer hohen Leitfähigkeit zu versorgen, was hinsichtlich des Stromflusses wünschenswert ist.

Hinsichtlich der Konfiguration der Elektrodenanordnung hat es sich weiter als zweckmäßig herausgestellt, wenn die Begleitelektroden an der Eingangsseite über die Mittenelektrode hinaus nach vorne schnabelförmig geöffnet sind. Diese Ausgestaltung ermöglicht es, den von einer äußeren Elektronenquelle stammenden Elektronenstrahl in die Einschluss-Trajektorie des Elektronenstrahlteilers einzufangen. Insbesondere hat es sich gezeigt, dass hierbei elektrische Streufelder reduziert und damit eine hierdurch bedingte Auslenkung der Elektronentrajektorie und/oder eine Anregung der Elektronen unterdrückt werden kann.

Durch eine Zusammenführung der Zwischenelektroden an der Eingangsseite resultiert dort das zu einer sicheren Führung der Elektronen gewünschte Quadrupol-Feld.

In einer weiter bevorzugten Variante ist die Mittenelektrode des Elektronenstrahlteilers an der Ausgangsseite gegabelt. Über diese Gabelung werden letztendlich zwei Elektronen-Trajektorien auseinandergeführt, so dass eine große Aufspaltung des Elektronenstrahls ermöglicht ist.

Weiter hat es sich als vorteilhaft erwiesen, wenn die Mittenelektrode gegenüber den Begleitelektroden von der Eingangsseite zur Ausgangsseite hin über einen überwiegenden Teil ihrer Gesamtlänge eine geringere transversale Breite aufweist. Für ein eintreffendes Elektron wird auf diese Weise eine sich über eine möglichst lange Strecke oder über einen möglichst langen Zeitraum erstreckende Auftrennung erreicht. Mit anderen Worten sieht ein eintreffendes Elektron in Vorwärtsrichtung einen sich langsam aufbauenden vergleichsweise niedrigen Potenzialwall vor sich, wodurch eine möglichst adiabatische Aufspaltung erreicht werden kann. Besonders vorteilhaft hierbei ist es, wenn sich die Mittenelektrode von der Ausgangsseite hin zur Eingangsseite stetig verjüngt. Das Elektron wird auf diese Art und Weise von einem Quadrupol-Feld mit einem parabelförmigen Pseudopotenzial allmählich, also über einen "sanften" Kreuzungsbereich, in ein Hexapol-Feld mit zwei lokal voneinander getrennten Einschlussminima geführt. Die Mittenelektrode erstreckt sich hierbei bevorzugt bis nahe an die Eingangsseite. Die Dicke der Mittenelektrode an deren vorderem Ende ist hierbei innerhalb vorgegebener Fertigungsgrenzen minimiert.

Weiter vorteilhaft verändert sich die transversale Breite der Begleitelektroden an dem Bereich der Eingangsseite entlang des Pfades mit einer variierenden Steigung. Die Variation der Steigung ist wiederum vorteilhaft zur Reduzierung von elektrischen Streufeldern und somit zur Verringerung des Verlusts an Elektronen oder einer Auslenkung der Elektronentrajektorie. Auch werden hierdurch die Trajektorien der eingespeisten Elektronen möglichst rasch parallelisiert. Vorteilhaft hierzu nimmt die transversale Breite der Begleitelektroden in diesem Bereich abschnittsweise zu und ab.

Entsprechend verändert sich die transversale Breite der Begleitelektroden in einem Bereich an der Ausgangsseite mit einer variierenden Steigung. Vorteilhaft hierbei nimmt auch die transversale Breite der Begleitelektroden im Bereich an der Ausgangsseite abschnittsweise zu und ab.

Zweckmäßigerweise bleibt die transversale Breite der Begleitelektroden in einem Mittenabschnitt der Elektrodenanordnung im Wesentlichen gleich. Über die Länge des Mittenabschnitts kann auch Bezug auf die Elektronenenergie genommen werden.

Ausführungsbeispiele der Erfindung werden anhand einer Zeichnung näher erläutert. Dabei zeigen:
- Fig. 1: schematisch einen auf einem Substrat gefertigten Elektronenstrahlteiler von oben,
- Fig. 2: den Elektronenstrahlteiler gemäß Fig. 1 von unten,
- Fig. 3: die Elektrodenanordnung eines flächigen Elektronenstrahlteilers im Detail,
- Fig. 4: die durch die Elektrodenkonfiguration gemäß Fig. 3 im Bereich der Eingangsseite und im Bereich der Ausgangsseite erzeugten Pseudopotenziale,
- Fig. 5: den Verlauf einer Isopotenzialfläche des Pseudopotentialsentlang einer Elektrodenanordnung gemäß Fig. 3 und
- Fig. 6: die Aufenthaltswahrscheinlichkeiten für Elektronen im Grundzustand entlang des Kreuzungsbereiches der Pseudopotenziale einer Elektrodenkonfiguration ähnlich Fig. 3.

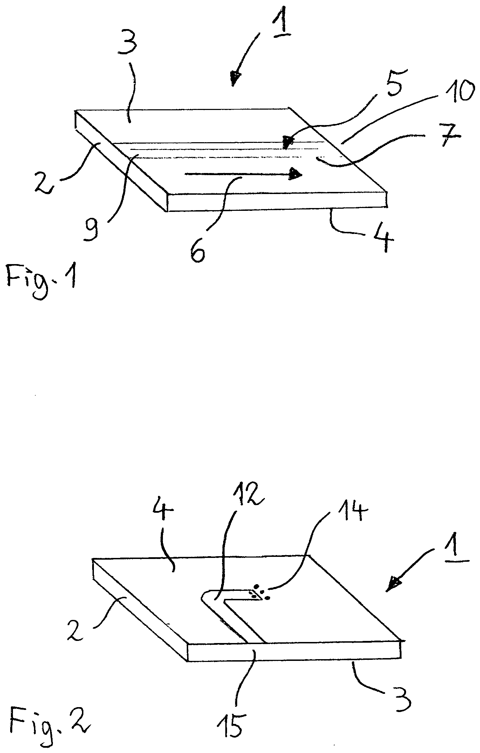

Fig. 1 zeigt schematisch einen Elektronenstrahlteiler 1, der auf einem ebenen Substrat 2 ausgebildet ist. Das Substrat 2 ist ein für Mikrowellen-Anwendungen geeignetes Substrat 2 und insbesondere aus einem Teflonlaminat gefertigt. Auf seiner Oberseite ist beispielsweise eine leitfähige Schicht 3 aus Kupfer/Gold aufgebracht. Es kann aber auch ein anderes Substrat 2 eingesetzt werden, dass ein niedrige Dielektrizitätskonstante und einen geringen Mikrowellen-Verlustfaktor aufweist. Als leitfähige Beschichtung sind Materialien mit einer hohen Leitfähigkeit zu wählen. Auch auf seiner Unterseite ist eine entsprechende leitfähige Schicht 4 angeordnet. Auf der Oberseite ist durch chemisches Ätzen der jeweiligen Konturen aus der leitfähigen Schicht 3 eine Elektrodenanordnung 5 herausgebildet, die den eigentlichen Elektronenstrahlteiler 1 bildet. Die Elektrodenanordnung 5 erstreckt sich hierbei entlang eines Pfades 6, der zugleich im Wesentlichen die Bewegungsrichtung bzw. die Trajektorie für den aufzuspaltenden Elektronenstrahl angibt. Die einzelnen Elektroden 7 der Elektrodenanordnung 5 sind angedeutet. Die Elektrodenanordnung 5 erstreckt sich von einer Eingangsseite 9 hin zu einer Ausgangsseite 10.

In Fig. 2 ist der Elektronenstrahlteiler 1 entsprechend Fig. 1 von unten dargestellt. In die leitfähige Schicht 4 auf der Unterseite des Substrats 2 ist durch chemisches Ätzen der Konturlinie eine Mikrowellenzuleitung 12 ausgebildet. Am Ende der Mikrowellenzuleitung 12 sind Durchkontaktierungen 14 angeordnet, die sowohl die Mikrowellenzuleitung 12 als auch die leitfähige Schicht 4 auf der gegenüberliegenden Seite mit den entsprechenden Elektroden 7 der Elektrodenanordnung 5 kontaktieren. Am äußeren Ende der Mikrowellenzuleitung 12 befindet sich eine Anschlussseite 15 zum Anschluss an eine geeignete HF-Quelle. Das HF-Signal wird hierbei in die Mikrowellenzuleitung 12 eingespeist. Die umgebende leitfähige Schicht 4 der Unterseite und die umgebende leitfähige Schicht 3 der Oberseite werden hiergegenüber jeweils mit Masse kontaktiert.

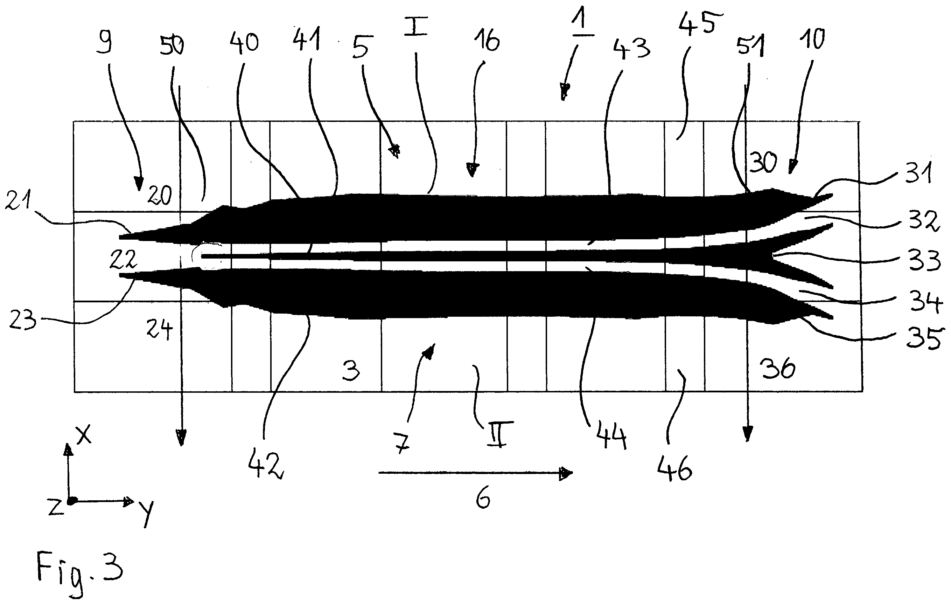

In Fig. 3 ist im Detail eine im Hinblick auf eine möglichst verlustfreie Aufspaltung der Elektronen optimierte Elektrodenanordnung 5 eines Elektronenstrahlteilers 1 dargestellt. Entsprechend Fig. 1 erstreckt sich die Elektrodenanordnung 5 entlang eines Pfades 6 von einer Eingangsseite 9 zu einer Ausgangsseite 10. Unterstützend sind in Fig. 3 die Raumrichtungen X,Y,Z eines kartesischen Koordinatensystems eingezeichnet. Der aufzuspaltende Elektronenstrahl wird von links eingespeist, durchquert die Elektronenanordnung 5 in Y-Richtung und verlässt diese in zwei aufgespaltenen Teilstrahlen an der Ausgangsseite 10. Zwischen der Eingangsseite 9 und der Ausgangsseite 10 weist die Elektrodenanordnung 5 einen Mittenbereich 16 auf, dessen Länge im Hinblick auf die longitudinale Elektronenenergie abgestimmt ist und eine Aufspaltung des Elektronenstrahls mit einer möglichst geringen transversalen Anregung ermöglicht.

Die Elektrodenanordnung 5 ist flächig und auf einem beschichteten und insbesondere ebenen Substrat 2 gemäß Fig. 1 und 2 ausgebildet. Dabei sind die einzelnen erkennbaren Elektroden 7 in der leitfähigen Schicht 3 auf der Oberseite des Substrats 2 dadurch gebildet, dass entlang ihrer jeweiligen Trennkonturen die leitfähige Schicht 3 durch chemisches Ätzen entfernt ist. Die unterschiedliche Einfärbung der Elektroden 7 dient lediglich zur besseren Sichtbarmachung.

In einer ersten Sichtweise zeigt die Elektrodenanordnung 5 an der Eingangsseite in Richtung des dargestellten Pfeils eine erste Elektrode 20, eine zweite Elektrode 21, eine dritte Elektrode 22, eine vierte Elektrode 23 und eine fünfte Elektrode 24. Diese insgesamt fünf Elektroden 20-24 stellen einen auf eine Ebene abgerollten elektrischen Quadrupol dar. In Richtung des Pfeils benachbarte Elektroden 20-24 liegen jeweils auf unterschiedlichem Potenzial. Werden die Elektroden 20-24 mit einer hochfrequenten Wechselspannung beaufschlagt, so resultiert ein oszillierendes elektrisches Quadrupol-Feld, was zu einem zeitlich gemittelten Pseudopotenzial mit einem lokalen zentralen Einschlussminimum in der X,Z-Ebene oberhalb der mittleren Elektrode 22 führt. Über dieses Pseudopotenzial erfolgt ein transversaler Einschluss der sich in Richtung des Pfads 6 bewegenden Elektronen.

An der Ausgangsseite 10, und auch im Mittenbereich 16, sind entlang des eingezeichneten Pfeils eine erste Elektrode 30, eine zweite Elektrode 31, eine dritte Elektrode 32, eine vierte Elektrode 33, eine fünfte Elektrode 34, eine sechste Elektrode 35 und eine siebte Elektrode 36 angeordnet. Benachbarte Elektroden 30-36 liegen wiederum jeweils auf unterschiedlichem Potenzial. Diese Konfiguration entspricht damit einem auf einer Ebene abgerollten Hexapol. Unter Spannungsbeaufschlagung erzeugen die Elektroden 30-36 an der Ausgangsseite 10 ein oszillierendes Hexapol-Feld, dessen zeitlich gemitteltes Pseudopotenzial zwei in transversaler Richtung beabstandete Einschlussminima zeigt, die jeweils in Z-Richtung oberhalb der dritten Elektrode 32 bzw. der fünften Elektrode 34 liegen. Die Elektroden werden somit an der Ausgangsseite in transversal zueinander beabstandeten Trajektorien longitudinal geführt. Das aus dem Hexapol-Feld resultierende Pseudopotenzial führt zu einer longitudinalen Führung entlang der vorgegebenen Trajektorien.

Über den Mittenbereich 16 wird für Elektronen ein kontinuierlicher und im Wesentlichen paralleler Übergang von einer einzelnen geführten Einschluss-Trajektorie in zwei geführte Einschluss-Trajektorien erreicht. Ein einzelnes Elektron wird insofern in Ausbreitungsrichtung im Wesentlichen nicht abgebremst und verbleibt gewünscht in seinem transversalen Grundzustand. Im quantenmechanischen Bild ist die Aufenthaltswahrscheinlichkeit des Elektrons in den beiden Trajektorien auf der Ausgangsseite gleich.

Betrachtet man die gegebene Elektrodenanordnung 5 entlang des Pfads 6 geometrisch, so können in einer ersten Gruppe I (dunkel eingefärbt) eine Mittenelektrode 40 sowie zwei die Mittenelektrode 40 entlang des Pfads 6 flankierende Begleitelektroden 41 und 42 erkannt werden. In einer zweiten Gruppe II (weiß gefärbt) können zwei zwischen der Mittenelektrode 40 und jeweils einer Begleitelektrode 41,42 angeordnete Zwischenelektroden 43,44 und zwei Außenelektroden 45 und 46 erkannt werden. Dabei sind die Elektroden 40,41,42 (dunkel gefärbt) der ersten Gruppe I mit dem einen Pol und die Elektroden 43,44,45,46 (weiß gefärbt) der zweiten Gruppe II mit dem anderen Pol der Spannungsquelle verbunden.

Die Elektroden 43,44,45,46 der zweiten Gruppe II sind unmittelbar als noch zusammenhängende leitfähige Schicht 3 erkennbar. Die Elektroden 40,41,42 der ersten Gruppe I sind durch chemisches Ätzen ihrer Konturen aus der leitfähigen Schicht 3 herausgearbeitet.

Es wird ersichtlich, dass die beiden Begleitelektroden 41,42 nach vorne schnabelförmig geöffnet sind. Im Bereich der Eingangsseite 9 variiert zudem ihre transversale Breite entlang des Pfads 6. Dabei sind abschnittsweise Bereiche mit zunehmender und mit abnehmender Breite ersichtlich. Hierdurch wird das Einkoppeln eines von einer externen Elektronenquelle stammenden Elektronenstrahls erleichtert. Insbesondere werden hierdurch unerwünschte elektrische Streufelder unterdrückt.

An der Ausgangsseite 10 weist die Elektrodenanordnung 5 eine bezüglich der Eingangsseite 9 im Wesentlichen transversal verdoppelte Konfiguration auf. Zur Auftrennung der getrennten Trajektorien ist an dieser Stelle die Mittenelektrode 40 gegabelt.

Die beiden Zwischenelektroden 43,44 weisen von der Eingangsseite 9 bis zur Ausgangsseite 10 gegebenenfalls mit Ausnahme des Gabelungsbereiches eine gleichbleibende transversale Breite auf. Die Mittenelektrode 40 verjüngt sich im dargestellten Ausführungsbeispiel von der Ausgangsseite 10 in Richtung zur Eingangsseite 9 monoton. Die transversale Breite der Mittenelektrode 40 ist entlang eines überwiegenden Teils ihrer Gesamtlänge von der Eingangsseite 9 zur Ausgangsseite 10 hin mit einer gegenüber den Begleitelektroden 41,42 geringeren transversalen Breite ausgebildet. Im Mittenbereich 16 bleibt die transversale Breite der Begleitelektroden 41,42 im Wesentlichen gleich.

Die dargestellte Elektrodenanordnung weist insgesamt eine Länge von etwa 40 mm auf. An der Ausgangsseite 9 sind die beiden Elektronen-Trajektorien um 2 mm voneinander getrennt. Für Elektronen einer Energie zwischen 0,5 eV und 3,5 eV und einer Wechselspannungsfrequenz von 1 GHz konnte eine weitgehend verlustfreie Aufspaltung des Elektronenstrahls gezeigt werden. Es hat sich gezeigt, dass eine solche oder ähnliche Elektrodenanordnung grundsätzlich in der Lage ist, bei der Wahl einer Wechselspannungsfrequenz von 10 GHz, einer kinetischen Energie der Elektronen von 1 eV und einer Spannung von 100 V, eine adiabatische und kohärente Aufspaltung der Elektronen zu bewirken.

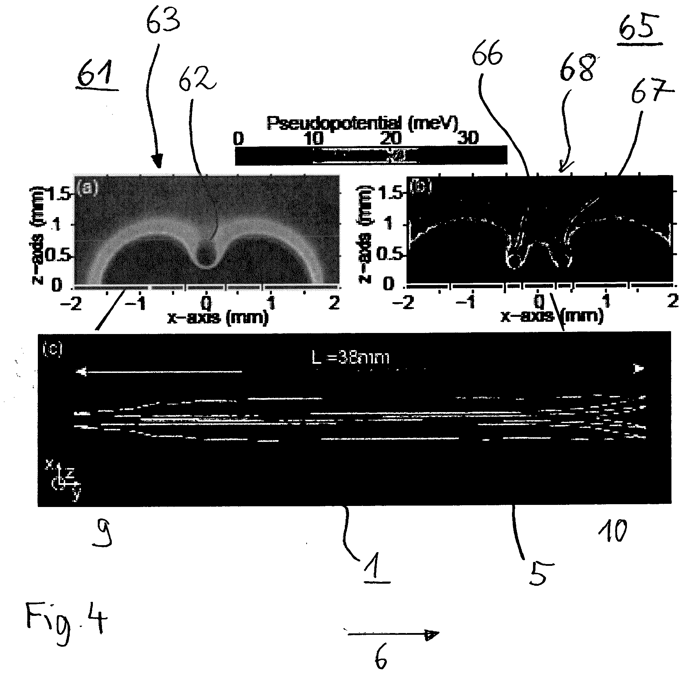

In Fig. 4 sind die sich mit der in Fig. 3 dargestellten Elektrodenkonfigurationen 5 ergebenden zeitlich gemittelten elektrischen Felder 61, 65 bzw. die resultierenden Pseudopotenziale 63, 68 an der Eingangsseite 9 und an der Ausgangsseite 10 dargestellt. Das aus dem oszillierenden elektrischen Feld 61 an der Eingangsseite 9 resultierende Pseudopotenzial 63 weist ein einzelnes lokales Einschlussminimum 62 auf. Das umgebende Potenzial ist in transversaler Richtung im Wesentlichen parabelförmig. Das lokale Einschlussminimum 62 ist etwa 500 µm oberhalb der Elektrodenanordnung 5 gebildet.

Das sich aus dem oszilierenden elektrischen Feld 65 an der Ausgangsseite 10 der Elektrodenanordnung 5 ergebende Pseudopotenzial 68 zeigt zwei im mm-Bereich voneinander getrennte Einschlussminima 66, 67, die etwa 400 µm oberhalb der Elektrodenanordnung 5 angeordnet sind.

In den jeweiligen, sich lokal ergebenden Einschlussminima 62, 65, 67 sind Elektronen transversal eingeschlossen und werden longitudinal in Richtung des Pfads 6 geführt.

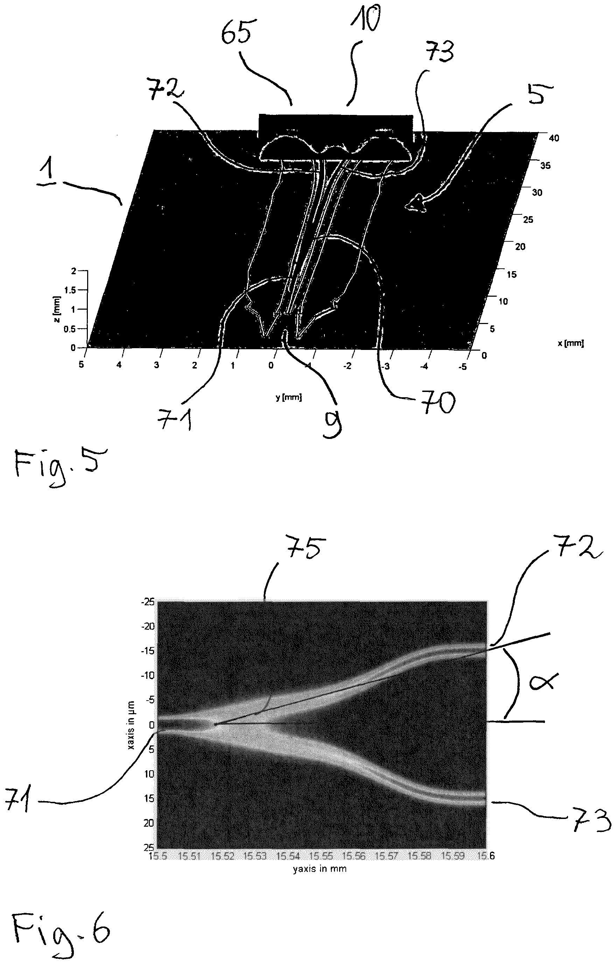

In Fig. 5 ist eine Isopotenzialfläche 70 des sich entlang der Elektrodenanordnung 5 ergebenden Pseudopotenzials dargestellt. An der Eingangsseite 9 ist ein einzelner Ast 71 gegeben. Dieser Ast 71 spaltet sich entlang der Elektrodenanordnung 5 in zwei separate Äste 72 und 73 auf. An der Ausgangsseite 10 wird verdeutlicht, wie die getrennten Äste 72,73 den beiden lokalen Einschlussminima des Pseudopotenzials 65 zugeordnet sind.

In Fig. 6 ist ein optimierter Kreuzungsbereich 75 eines Elektronenstrahlteilers dargestellt, wie er sich beispielsweise für eine Elektrodenanordnung 5 ähnlich Fig. 3 oder Fig. 5 ergeben könnte. Dabei ist quantenmechanisch die Aufenthaltswahrscheinlichkeit für Elektronen im jeweiligen Grundzustand dargestellt. Man erkennt, dass sich die Elektronen im einzelnen Ast 70 in ihrem Grundzustand befinden. Auch nach der Auftrennung befinden sich die Elektronen in den jeweiligen Ästen 72,73 im jeweiligen Grundzustand. Im Kreuzungsbereich 75 ist der Öffnungswinkel α der sich auftrennenden Äste 72, 73 im Pseudopotenzial eingezeichnet. Für eine möglichst verlustfreie und adiabatische Aufspaltung sollte dieser Winkel bei Elektronenenergien von 1 eV bis 10 eV zwischen 0,005° und 0,04° liegen.

Aus den Fig. 5 und 6 wird auch ersichtlich, dass sich der Kreuzungsbereich über eine vergleichsweise lange Strecke erstreckt. Mit anderen Worten erfolgt die Aufspaltung der Elektronen im Wesentlichen parallel. Hierdurch kann eine adiabatische und kohärente Aufspaltung erzielt werden. Erreicht wird dies im Wesentlichen durch die aus Fig. 3 ersichtliche, sich nach vorne verjüngende Mittenelektrode 40 und dem vergleichsweise kleinen Öffnungswinkel α der sich auftrennenden Einschlussminima 66, 67 bzw. Äste 72, 73 im Pseudopotential.

### Bezugszeichenliste

- 1: Elektronenstrahlteiler
- 2: Substrat
- 3: leitfähige Schicht, Oberseite
- 4: leitfähige Schicht, Unterseite
- 5: Elektrodenanordnung
- 6: Pfad
- 7: Elektroden
- 9: Eingangsseite
- 10: Ausgangsseite
- 12: Mikrowellenzuleitung
- 14: Durchkontaktierungen
- 15: Anschlussseite
- 16: Mittenbereich
- 20: Elektrode, Eingangsseite
- 21: Elektrode, Eingangsseite
- 22: Elektrode, Eingangsseite
- 23: Elektrode, Eingangsseite
- 24: Elektrode, Eingangsseite
- 30: Elektrode, Ausgangsseite
- 31: Elektrode, Ausgangsseite
- 32: Elektrode, Ausgangsseite
- 33: Elektrode, Ausgangsseite
- 34: Elektrode, Ausgangsseite
- 35: Elektrode, Ausgangsseite
- 36: Elektrode, Ausgangsseite
- 40: Mittenelektrode
- 41: Begleitelektrode
- 42: Begleitelektrode
- 43: Zwischenelektrode
- 44: Zwischenelektrode
- 45: Außenelektrode
- 46: Außenelektrode
- 50: Außenkontur
- 51: Außenkontur
- 61: elektrisches Feld
- 62: Einschlussminimum
- 63: Pseudopotenzial
- 65: elektrisches Feld
- 66: Einschlussminimum
- 67: Einschlussminimum
- 68: Pseudopotenzial
- 70: Elektronentrajektorie
- 71: Ast
- 72: Ast
- 73: Ast
- 75: Kreuzungsbereich

## Patentansprüche

1. Elektronenstrahlteiler (1) umfassend eine mehrpolige mit einer hochfrequenten Wechselspannung beaufschlagbare Elektrodenanordnung (5), die sich entlang eines vorgegebenen Pfades (6) von einer Eintrittsseite (9) zu einer Austrittsseite (10) erstreckt, wobei die Elektrodenanordnung (5) an der Eintrittsseite (9) mit einer ersten Anzahl von spannungsbeaufschlagten Elektroden (7) ein erstes oszillierendes elektrisches Feld (61) erzeugt, das in einer Transversalebene zeitgemittelt ein einzelnes lokales Einschlussminimum (62) bildet, und wobei die Elektrodenanordnung (5) zumindest an der Ausgangsseite (10) mit einer zweiten Anzahl von spannungsbeaufschlagten Elektroden (7) ein zweites oszillierendes Feld (65) erzeugt, das in einer Transversalebene zeitgemittelt wenigstens zwei lokale Einschlussminima (66, 67) bildet.

2. Elektronenstrahlteiler (1) nach Anspruch 1,
wobei die Elektrodenanordnung (5) derart ausgebildet ist, dass in einem Übergangsbereich eines einzelnen lokalen Einschlussminimums (62) auf zwei lokale Einschlussminima (66, 67) der Öffnungswinkel α zwischen den beiden lokalen Einschlussminima (66, 76) zwischen 0,005° und 0,04° beträgt.

3. Elektronenstrahlteiler (1) nach Anspruch 1 oder 2,
wobei die Länge der Elektrodenanordnung (5) entlang des Pfades (6) zwischen 1 mm und 100 mm, insbesondere zwischen 10 mm und 50 mm beträgt.

4. Elektronenstrahlteiler (1) nach einem der vorhergehenden Ansprüche, wobei die erste Anzahl von Elektroden (7) kleiner als die zweite Anzahl von Elektroden (7) ist.

5. Elektronenstrahlteiler (1) nach einem der vorhergehenden Ansprüche,
wobei die Elektroden (7) der Elektrodenanordnung (5) an der Eingangsseite (9) derart angeordnet und ausgebildet sind, dass sie unter Spannungsbeaufschlagung ein oszillierendes elektrisches Feld mit einem Quadrupol-Anteil erzeugen.

6. Elektronenstrahlteiler (1) nach einem der vorhergehenden Ansprüche,
wobei die Elektroden (7) der Elektrodenanordnung (5) der Eingangsseite (9) nachfolgend derart angeordnet und ausgebildet sind, dass sie ein oszillierendes elektrisches Feld mit einem Hexapol-Anteil oder mit einem Multipol-Anteil noch höherer Ordnung erzeugen.

7. Elektronenstrahlteiler (1) nach einem der vorhergehenden Ansprüche,
wobei die Elektroden (7) der Elektrodenanordnung (5) an der Ausgangsseite (10) derart angeordnet und ausgebildet sind, dass sie ein oszillierendes elektrisches Feld mit wenigstens zwei in Transversalrichtung zueinander versetzten Quadrupol-Anteilen erzeugen.

8. Elektronenstrahlteiler (1) nach Anspruch 7,
wobei die Elektrodenanordnung (5) an der Ausgangsseite (10) eine wenigstens zweifach in Transversalrichtung vervielfältige Struktur der Eingangsseite (9) aufweist.

9. Elektronenstrahlteiler (1) nach einem der vorhergehenden Ansprüche,
wobei die Elektrodenanordnung (5) entlang des Pfades (6) in einer ersten Gruppe von Elektroden (7) eine Mittenelektrode (40) sowie zwei die Mittenelektrode (40) flankierende Begleitelektroden (41, 42) und in einer zweiten Gruppe von Elektroden (7) zwei jeweils zwischen einer Begleitelektrode (41, 42) und der Mittenelektrode (40) angeordnete Zwischenelektroden (43, 44) sowie zwei jeweils den Begleitelektroden (41, 42) bezüglich der Mittenelektrode (40) außen angrenzende Außenelektroden (45, 46) umfasst, wobei die Elektroden (7) innerhalb einer Gruppe jeweils elektrisch miteinander verbunden sind, und wobei die Elektroden (7) der ersten Gruppe und die Elektroden (7) der zweiten Gruppe zueinander elektrisch getrennt sind.

10. Elektronenstrahlteiler (1) nach einem der vorhergehenden Ansprüche,
wobei die Elektroden (7) der Elektrodenanordnung (5) auf einer Fläche, insbesondere auf einer Ebene, angeordnet sind.

11. Elektronenstrahlteiler (1) nach Anspruch 10,
wobei die Elektroden (7) jeweils als leitfähige Schichten auf einem Substrat (2) angeordnet sind.

12. Elektronenstrahlteiler (1) nach Anspruch 11,
wobei das Substrat (2) doppelseitig leitfähig beschichtet ist.

13. Elektronenstrahlteiler (1) nach einem der Ansprüche 9 bis 12,
wobei die Elektroden (7) der zweiten Gruppe als eine zusammenhängende elektrisch leitfähige Schicht (3) gebildet sind, in welcher Schicht (3) die Elektroden (7) der ersten Gruppe elektrisch isoliert eingebettet sind.

14. Elektronenstrahlteiler (1) nach einem der Ansprüche 9 bis 13,
wobei die Begleitelektroden (41, 42) an der Eingangsseite (9) über die Mittelelektrode (40) hinaus nach vorne schnabelförmig geöffnet sind.

15. Elektronenstrahlteiler (1) nach einem der Ansprüche 9 bis 14,
wobei die Zwischenelektroden (43, 44) an der Eingangsseite (9) zusammengeführt sind.

## Claims

1. Electron beam splitter (1), comprising a multipole electrode arrangement (5) which can be impacted by a high-frequency alternating voltage and which extends along a predetermined path (6) from an inlet side (9) to an outlet side (10), wherein the electrode arrangement (5) generates, on the inlet side (9), a first oscillating electric field (61) with a first number of voltage-impacted electrodes (7), which forms in a transverse plane in a time-averaged manner a single local confinement minimum (62), and wherein the electrode arrangement (5) generates, at least on the outlet side (10), with a second number of voltage-impacted electrodes (7), a second oscillating field (65), which forms in a transverse plane in a time-averaged manner at least two local confinement minima (66, 67).

2. The electron beam splitter (1) according to claim 1, wherein the electrode arrangement (5) is formed in such a way that in one crossover region of a single local confinement minimum (62) to two local confinement minima (66, 67), the opening angle α between both local confinement minima (66, 67) is between 0.005° and 0.04 °.

3. The electron beam splitter (1) according to claim 1 or 2, wherein the length of the electrode arrangement (5) along the path (6) is between 1 mm and 100 mm, in particular between 10 mm and 50 mm.

4. The electron beam splitter (1) according to one of the preceding claims, wherein the first number of electrodes (7) is smaller than the second number of electrodes (7).

5. The electron beam splitter (1) according to one of the preceding claims, wherein the electrodes (7) of the electrode arrangement (5) on the inlet side (9) are arranged and formed in such a way that they generate, when a voltage is applied, an oscillating electric field with a quadrupole component.

6. The electron beam splitter (1) according to one of the preceding claims, wherein the electrodes (7) of the electrode arrangement (5) of the inlet side (9) are subsequently arranged and formed in such a way that they generate an oscillating electric field with a hexapole component, or with a multipole component of a still higher order.

7. The electron beam splitter (1) according to one of the preceding claims, wherein the electrodes (7) of the electrode arrangement (5) on the outlet side (10) are arranged and formed in such as way that they generate an oscillating electric field with at least two quadrupole components which are staggered relative to each other in the transverse direction.

8. The electron beam splitter (1) according to claim 7, wherein the electrode arrangement (5) is provided at least twice with a duplicate structure of the inlet side (9) in the transverse direction.

9. The electron beam splitter (1) according to one of the preceding claims, wherein the electrode arrangement (5) along the path (6) in a first group of electrodes (7) comprises a center electrode (40), as well as two accompanying electrodes (41, 42) flanking the center electrode (40), and in a second group of electrodes (7) comprises two intermediate electrodes (43, 44) arranged between an accompanying electrode (41, 42) and the center electrode (40), respectively, as well as two external electrodes (45, 46), which are externally adjacent in each case to the accompanying electrodes (41, 42) with respect to the center electrode (40), wherein the electrodes (7) are electrically connected to one another within one group, and wherein the electrodes (7) of the first group and the electrodes (7) of the second group are electrically separated from each other.

10. The electron beam splitter (1) according to one of the preceding claims, wherein the electrodes (7) of the electrode arrangement (5) are arranged on a surface, in particular on a plane.

11. The electron beam splitter (1) according to claim 10, wherein the electrodes (7) are respectively arranged as conductive layers on a substrate (2).

12. The electron beam splitter (1) according to claim 11, wherein the substrate (2) is coated so that it is conductive on both sides.

13. The electron beam splitter (1) according to one of the claims 9 through 12, wherein the electrodes (7) of the second group are formed as a contiguous, electrically conductive layer (3), the electrodes (7) of the first group being electrically insulated and embedded in the layer (3).

14. The electron beam splitter (1) according to one of the claims 9 through 13, wherein the accompanying electrodes (41, 42) are open forward on the inlet side (9) in the shape of a beak beyond the center electrode (40).

15. The electron beam splitter (1) according to one of the claims 9 through 14, wherein the intermediate electrodes (43, 44) on the inlet side (9) are brought together.

## Revendications

1. Diviseur (1) de faisceau d'électrons comprenant un ensemble d'électrodes multipolaire (5) sur lequel une tension alternative à haute fréquence peut être appliquée et qui s'étend suivant un parcours prédéterminé (6) reliant un côté d'entrée (9) et un côté de sortie (10),
par un premier nombre d'électrodes (7) sur lesquelles une tension est appliquée, l'ensemble d'électrodes (5) formant sur le côté d'entrée (9) un premier champ électrique oscillant (61) présentant en moyenne dans un plan transversal un seul minimum local d'inclusion (62),
par un deuxième nombre d'électrodes (7) sur lesquelles une tension est appliquée, l'ensemble d'électrodes (5) formant au moins sur le côté de sortie (10) un deuxième champ oscillant (65) présentant en moyenne temporelle dans un plan transversal au moins deux minimums locaux d'inclusion (66, 67).

2. Diviseur (1) de faisceau d'électrons selon la revendication 1, dans lequel l'ensemble d'électrodes (5) est configuré de telle sorte que dans la zone de transition d'un unique minimum local d'inclusion (62) à deux minimums locaux d'inclusion (66, 67), l'angle d'ouverture α entre les deux minimums locaux d'inclusion (66, 76) soit compris entre 0,005° et 0,04°.

3. Diviseur (1) de faisceau d'électrons selon la revendication 1 ou 2, dans lequel la longueur de l'ensemble d'électrodes (5) le long du parcours (6) est comprise entre 1 mm et 100 mm et en particulier entre 10 mm et 50 mm.

4. Diviseur (1) de faisceau d'électrons selon l'une des revendications précédentes, dans lequel le premier nombre d'électrodes (7) est inférieur au deuxième nombre d'électrodes (7).

5. Diviseur (1) de faisceau d'électrons selon l'une des revendications précédentes, dans lequel les électrodes (7) de l'ensemble d'électrodes (5) sont disposées et formées sur le côté d'entrée (9) de telle sorte qu'elles forment lorsqu'une tension leur est appliquée un champ électrique oscillant présentant une portion quadripolaire.

6. Diviseur (1) de faisceau d'électrons selon l'une des revendications précédentes, dans lequel les électrodes (7) de l'ensemble d'électrodes (5) sont disposées et formées sur le côté d'entrée (9) de telle sorte qu'elles forment lorsqu'une tension leur est appliquée un champ électrique oscillant présentant une portion hexapolaire ou une portion multipolaire d'un ordre encore plus élevé.

7. Diviseur (1) de faisceau d'électrons selon l'une des revendications précédentes, dans lequel les électrodes (7) de l'ensemble d'électrodes (5) sont disposées et formées sur le côté de sortie (10) de manière à former un champ électrique oscillant qui présente au moins deux portions quadripolaires décalées l'une par rapport à l'autre dans la direction transversale.

8. Diviseur (1) de faisceau d'électrons selon la revendication 7, dans lequel l'ensemble d'électrodes (5) présente sur le côté de sortie (10) une structure multipliée dans la direction transversale deux fois par rapport au côté d'entrée (9).

9. Diviseur (1) de faisceau d'électrons selon l'une des revendications précédentes, dans lequel l'ensemble d'électrodes (5) comporte le long du parcours (6), dans un premier groupe d'électrodes (7) une électrode centrale (40) ainsi que deux électrodes d'accompagnement (41, 42) qui flanquent l'électrode centrale (40) et dans un deuxième groupe d'électrodes (7), deux électrodes intermédiaires (43, 44) disposées entre une électrode d'accompagnement (41, 42) et l'électrode centrale (40) ainsi que deux électrodes extérieures (45, 46) adjacentes aux électrodes d'accompagnement (41, 42) à l'extérieur de l'électrode centrale (40), les électrodes (7) d'un groupe étant reliées électriquement les unes aux autres et les électrodes (7) du premier groupe et les électrodes (7) du deuxième groupe étant séparées électriquement les unes des autres.

10. Diviseur (1) de faisceau d'électrons selon l'une des revendications précédentes, dans lequel les électrodes (7) de l'ensemble d'électrodes (5) sont disposées sur une surface et en particulier dans un plan.

11. Diviseur (1) de faisceau d'électrons selon la revendication 10, dans lequel les électrodes (7) sont disposées sous la forme de couches conductrices sur un substrat (2).

12. Diviseur (1) de faisceau d'électrons selon la revendication 11, dans lequel le substrat (2) est doté d'une couche conductrice sur ses deux faces.

13. Diviseur (1) de faisceau d'électrons selon l'une des revendications 9 à 12, dans lequel les électrodes (7) du deuxième groupe sont formées comme couches (3) électriquement conductrices continues, les électrodes (7) du premier groupe étant incorporées dans la couche (3) en étant électriquement isolées les unes des autres.

14. Diviseur (1) de faisceau d'électrons selon l'une des revendications 9 à 13, dans lequel du côté de l'entrée (9), les électrodes d'accompagnement (41, 42) sont ouvertes vers l'avant en forme de bec débordant de l'électrode centrale (40).

15. Diviseur (1) de faisceau d'électrons selon l'une des revendications 9 à 14, dans lequel les électrodes intermédiaires (43, 44) sont rassemblées sur le côté d'entrée (9).
